# EUROPEAN PATENT SPECIFICATION

(11) **EP 2 615 613 B1**
(45) Date of publication and mention of the grant of the patent: **17.09.2014**
(21) Application number: 12188575.0
(22) Date of filing: 15.10.2012
(51) Int. Cl.: H01B 1/22, H01L 31/0224, H01L 31/18

(54) **A solar cell back side electrode**
Solarzellen-Rückseitenelektrode
Électrode du côté arrière de cellule solaire

(30) Priority: 16.01.2012 US 201261586969 P
(43) Date of publication of application: 17.07.2013
(73) Proprietor: E. I. du Pont de Nemours and Company, Wilmington, DE 19898 (US)
(72) Inventor: Akimoto, Hideki, Kawasaki Kanagawa, 210-0006 (JP); Barker, Michael F., Tokyo, 154-0012 (JP); Kikuchi, Chieko, Kawasaki Kanagawa, 210-0006 (JP)
(74) Representative: Hoffmann, Benjamin

(56) References cited:
- WO-A1-2010/117773
- WO-A1-2010/135535
- WO-A1-2013/036689
- US-A1- 2011 120 535
- US-A1- 2011 120 551

## Description

### FIELD OF THE INVENTION

The present invention relates to a solar cell, more specifically to a back side electrode and the method of manufacturing it.

### TECHNICAL BACKGROUND OF THE INVENTION

A solar cell having a passivation layer on the back side of a semiconductor layer has been proposed as a Passivated Emitter and Rear Cell (PERC). A back side electrode for the PERC needs sufficient adhesion.

JP1997045945 discloses a solar cell having a passivation layer with openings at the back side, and a back side electrode is formed by plating method or vacuum deposition method with aluminum.

US2011/0120535 discloses an aluminum paste used to form back side electrodes in solar cells.

US20090056798 discloses a method of forming a back side electrode for a PERC by using an aluminum paste. The aluminum paste contains a glass frit comprising 15-75 mol% of PbO, 5-75 mol% of (B₂O₃+SiO₂), 0-55 mol% of ZnO, 0-40 mol% of (Li₂O+Na₂O+K₂O), 0-20 mol% of (TiO₂+ZrO₂). However, the aluminum paste fires through the passivation layer so that it's difficult to find a proper balance between the passivation layer coverage area and the back side electrode area. A larger area of back side electrode provides higher conductivity. However, when the Al paste fires through the passivation layer, a larger electrode area results in a smaller passivation area. A larger area of intact passivation area is desirable since it results in increased passivation effect, i.e., greater reduction of recombination.

### SUMMARY OF THE INVENTION

An objective is to provide a method of manufacturing a solar cell back side electrode by using an aluminum paste for the PERC.

One aspect relates to a method of manufacturing a solar cell back side electrode comprising:
(a) preparing a substrate comprising a semiconductor layer and a passivation layer formed on the back side of the semiconductor layer, wherein the passivation layer has one or more openings;
(b) applying, onto the back side of the substrate, an aluminum paste comprising:
   (i) an aluminum powder;
   (ii) a glass frit comprising 30 to 70 cation mole percent of lead (Pb²⁺), 1 to 40 cation mole percent of silicon (Si⁴⁺) and 10 to 65 cation mole percent of boron (B³⁺), and 1 to 25 cation mole percent of aluminum (Al³⁺), based on the total mole of cationic components in the glass frit, wherein the softening point of the glass frit is 330 to 550°C, and
   (iii) an organic medium, wherein the aluminum paste covers the one or more openings in the passivation layer thereby making electrical contact with the semiconductor layer; and
(c) firing the aluminum paste in a furnace, wherein the aluminum paste does not fire through the passivation layer during the firing.

The present invention results in a solar cell back side electrode with improved adhesion.

### BRIEF DESCRIPTION OF THE DRAWINGS

FIGS. 1A to 1D explain the process of manufacturing a solar cell back side electrode.
FIG. 2(a), (b), and (c) are drawings of pattern of openings formed in a passivation layer at the back side.

### DETAILED DESCRIPTION OF THE INVENTION

A method of manufacturing a solar cell back side electrode is explained below.

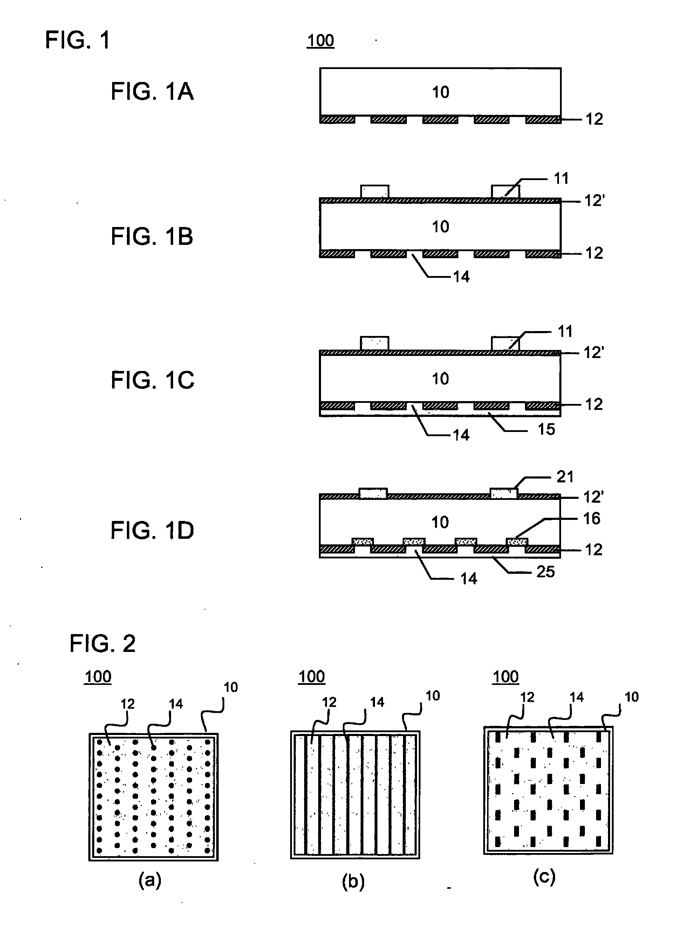

An example in which a solar cell back side electrode is prepared using an aluminum paste is explained referring to FIG. 1A to 1D.

A substrate 100 comprising a semiconductor layer 10, for example a silicon wafer, and a passivation layer 12 formed on the back side of the semiconductor layer 10 is prepared (FIG. 1A). Another passivation layer 12' can be formed at the front side as well. In the specification, "front side" is the light-receiving side when the solar cell is actually installed to generate electrode, and "back side" is the opposite side of the front side.

The passivation layer 12 on the back side has openings 14 at which the passivation layer is not formed or has been eliminated and the semiconductor layer surface is exposed. To make the openings 14, the passivation layer 12 can be formed on the entire surface of the back side and then partially ablated, for example by laser ablation.

Area of the openings 14 can be at least 0.1 % in an embodiment, at least 1% in another embodiment, at least 10% in another embodiment, based on the total area of the back side surface of the semiconductor layer 10. Area of the passivation layer openings 14 can be 50% or less in an embodiment, 30% or less in another embodiment, 15% or less in another embodiment, based on the total area of the back side surface of the semiconductor layer 10. In other words, at least 50% of the back side surface of the semiconductor layer 10 can be covered with the passivation layer 12 in an embodiment. By covering such an area with the passivation layer 12, recombination of holes and electrons near the back side surface can be reduced. The thickness of the passivation layer 12 can be 10 to 500 nm.

The passivation layer 12 can be formed with titanium oxide, aluminum oxide, silicon nitride, silicon oxide, or silicon carbon oxynitride. These oxides or nitrides can be applied by sputtering, plasma-enhanced chemical vapor deposition (PECVD), or a thermal CVD or plasma CVD. A multiple layer can be also available, for example, two layers of silicon nitride/silicon oxide or silicon nitride/aluminum oxide as the passivation layer 12.

For the formation of the passivation layer and the pattern of the openings, L. Gautero et al., Comparison of different rear contacting approaches for industrial PERC solarcells on MC-Si wafe, 25th EUPVSEC 2010-2CO.3.1, ISBN: 3-936338-26-4, Pages:1328-1331 (2010) can be referred to.

On the front side, a front electrode paste 11, for example Ag paste can be applied to form a front electrode. The front electrode paste 11 can be applied by screen printing with a line pattern (FIG. 1B).

An aluminum (Al) paste 15 is applied at least onto the back side of the substrate. The pattern of applying the Al paste 15 is not limited as long as it covers the openings 14. The Al paste 15 can be applied onto entire surface of the back side of the substrate 100 so that the Al paste 15 covers the passivation layer 12 and the openings 14 and consequently makes electrical contact with the semiconductor layer 10 (FIG. 1C). In another embodiment, the pattern of the applied Al paste 15 can be dots, straight lines, circular lines, or polygonal lines as long as the applied paste 15 covers the openings 14. When having such a shape, consumption of the Al paste 15 can be reduced, although a collective electrode might be necessary.

The applied Al paste 15 can be dried at 80 to 200°C in an oven for 1 to 20 minutes. The dried Al paste 15 can have a thickness of 10 to 50 µm. This drying step is not essential.

The back side electrode 25 and the front side electrode 21 are formed by firing the Al paste 15 and the front electrode paste 11 respectively, and back surface field (BSF) 16 is formed at the openings 14 where the back side electrode 25 contacts the semiconductor layer 10 (FIG. 1 D). During firing, the organic medium in the pastes can be essentially removed, for example, burned out or carbonized.

Firing can be carried out using a furnace, with the peak setting temperature of 600 to 1000°C for 1 second to 15 minutes. In another embodiment, the peak setting temperature can be from 400 to 600°C for 5 seconds to 23 minutes, and over 600°C for 3 seconds to 19 minutes Total firing time can be 10 seconds to 30 minutes in an embodiment, 20 seconds to 15 minutes in another embodiment, 30 seconds to 5 minutes in another embodiment. When firing for such times, the electrodes can be formed with less damage to the semiconductor layer. The firing time can be counted, for example, from entrance to exit of the furnace.

During firing, the passivation layer 12 is not fired through by the Al paste 15 so as to stay intact to give the effect of passivation at the back side. However, this does not mean to exclude a small amount of firing through of the Al paste 15 during firing. A certain level of firing-though can be acceptable as long as a sufficient area of passivation layer remains. A small amount of firing-through can occur as a result of various factors such as the effect of materials of the semiconductor layer or the passivation layer. For example, up to 5% decrease of the passivation layer area after firing compared to the area before firing is acceptable.

In the explanation above, the Al paste 15 and the front electrode paste 11 were fired at the same time, which is called co-firing. With co-firing, the process can be shorter and simpler to reduce production cost. Alternatively, the Al paste 15 and the front electrode paste 11 can be fired separately, for example by applying and firing the Al paste 15 first, and then applying and firing the front electrode paste 11 with different firing profiles, especially when an suitable firing condition is different for each paste.

The openings 14 can be a round shape with a diameter of 10 to 400 µm (FIG. 2 (a)). The opening 14 can be a line shape with width of 10 to 400 µm (FIG. 2 (b)). The opening 14 can be a short line shape with width of 10 to 400 µm and length of 0.5 to 10 mm (FIG. 2 (c)).

### Aluminium Paste

The aluminum paste to make a solar cell back side electrode is explained in detail below. The aluminum paste comprises (i) an aluminum powder, (ii) a glass frit, and (iii) an organic medium.

### (i) Aluminum Powder

An aluminum (Al) powder is a metal powder to transport electrical current in a back side electrode.

The aluminum powder can be 30 to 80 weight percent (wt%) in an embodiment, 55 to 78 wt% in another embodiment, and 63 to 75 wt% in another embodiment, based on the total weight of the Al paste. With such content of Al powder, the back side electrode can have sufficient conductivity.

In an embodiment, the Al powder can be flaky, nodular or spherical in shape.

Particle diameter (D50) can be 0.1 to 20 µm in an embodiment, 2 to 15 µm in another embodiment, and 5 to 10 µm in another embodiment. Al powder with such particle diameter can be adequately dispersed in an organic medium and smoothly applied, for example, screen printed. The particle diameter (D50) is obtained by measuring the distribution of the particle diameters by using a laser diffraction scattering method. The median (50^{th} percentile) of the particle size distribution as measured by volume is defined as D50. Microtrac model X-1 00 is an example of the commercially-available devices that can be used to make this measurement.

Purity of the Al powder can be at least 90 wt% in an embodiment, at least 95 wt% in another embodiment, and at least 97 wt% in another embodiment. The surface of the Al powder sometimes can be oxidized.

In an embodiment, the Al paste can comprise another metal such as palladium (Pd), copper (Cu), or nickel (Ni).

In an embodiment, the aluminum paste can comprise silver powder of 0.5 wt% or less based on the weight of the Al powder. In another embodiment, the aluminum paste can comprise no silver powder. The addition of too much silver powder can cause fire-through.

### (ii) Glass Frit

The glass frit is used as an inorganic binder. When firing the Al paste, the glass frit melts to bind Al powder and adhere to a substrate.

The content of the glass frit composition is expressed herein with cation mol percent (%) unless it is otherwise described. "Cation mol%" is defined as mol% of a cationic component based on the total mole of cationic components in the glass frit. The non-metal component such as hydrogen ion (H⁺) and oxonium ion (H₃O⁺) are not counted as cationic components.

The glass frit comprises at least 30 to 70 cation mole% of lead (Pb²⁺), 1 to 40 cation mole% of silicon (Si⁴⁺), 10 to 65 cation mole% of boron (B³⁺), and 1 to 25 cation mole% of aluminum (Al³⁺), based on the total mole of cationic components in the glass frit.

Pb²⁺ can be 32 to 62 cation mol% in another embodiment, 34 to 54 cation mol% in another embodiment, and 35 to 45 cation mol% in still another embodiment, based on the total mole of cationic components in the glass frit.

Si⁴⁺ can be 3 to 35 cation mol% in another embodiment, 6 to 31 cation mol% in another embodiment, and 8 to 25 cation mol% in still another embodiment, based on the total mole of cationic components in the glass frit.

B³⁺ can be 15 to 60 cation mol% in another embodiment, 23 to 55 cation mol% in another embodiment, and 32 to 50 cation mol% in still another embodiment, based on the total mole of cationic components in the glass frit.

Al³⁺ can be 1 to 20 cation mol% in an embodiment, 1.5 to 16 cation mol% in another embodiment, and 2 to 13 cation mol% in still another embodiment, based on the total mole of cationic components in the glass frit.

With these glass frit compositions, the back side electrode will have sufficient adhesion as seen in the Examples below.

These cationic components of Pb²⁺, Si⁴⁺, B³⁺ or Al³⁺ can be introduced into the glass frit as starting materials in the form of oxides, fluorids or hydroxides.

The starting material of Pb²⁺ can be lead(II) oxide (PbO), lead dioxide (PbO₂), trilead tetraoxide (Pb₃O₄) or lead difluoride (PbF₂); Si⁴⁺ can be silicon dioxide (SiO₂), or silicon tetrafluoride (SiF₄); B³⁺ can be diboron trioxide (B₂O₃), boric acid (H₃BO₃), boron phosphate (BPO₄) or boron trifluoride (BF₃); Al³⁺ can be aluminum(III) oxide (Al₂O₃), aluminum hydroxide (Al(OH)₃) or aluminum fluoride (AlF₃).

Softening point of the glass frit is 330 to 550°C and 380 to 490°C in another embodiment. When the softening point is in these ranges, glass frit can melt properly at a relatively low firing temperature. Here, "softening point" is measured by the fiber elongation method of ASTM C338-57.

The glass frit can be 0.1 to 10 wt% in an embodiment, 0.3 to 7.5 wt% in another embodiment, and 1.1 to 5 wt% in still another embodiment, based on the total weight of the Al paste. When the Al paste contains such amounts of the glass frit, the Al powder can be bound with the melted glass frit.

Particle diameter (D50) of the glass frit can be 0.1 to 5 µm in an embodiment, 0.3 to 3 µm in another embodiment, and 0.5 to 2 µm in still another embodiment. With such particle diameters, the glass frit can melt properly to bind Al powder. The particle diameter D50 can be determined as described above for the Al powder.

The glass frit described herein can be manufactured by a conventional glass making technique. The following procedure is one example. The metal oxides as ingredients are weighed then mixed in the desired proportions and heated in a furnace to form a melt in platinum alloy crucibles. As well known in the art, heating is conducted to a peak temperature of 800 to 1400°C and for a time such that the melt becomes entirely liquid and homogeneous.

The molten glass is then quenched between counter rotating stainless steel rollers to form a 10-15 mil thick platelet of glass. The resulting glass platelet is then milled to form a powder with its 50% volume distribution set between a desired target, for example 0.5 to 3.0 µm.

One skilled in the art of producing glass frit may employ alternative synthesis techniques such as but not limited to water quenching, sol-gel, spray pyrolysis, or others appropriate for making powder forms of glass. US patent application numbers US 2006/231803 and US 2006/231800, which disclose a method of manufacturing a glass useful in the manufacture of the glass frits described herein, are hereby incorporated by reference herein.

One skilled in the art would recognize that the choice of starting materials could unintentionally include an impurity that can be incorporated into the glass during processing. For example, the impurity can be present in the range of hundreds to thousands ppm. A solar cell with the back side electrode can have the effect of the present invention described herein, even if the glass frit includes an impurity.

If starting with a glass, one of skill in the art can calculate the percentages of cationic components or starting materials described herein by using methods known to one of skill in the art including, but not limited to: Inductively Coupled Plasma-Emission Spectroscopy (ICPES), Inductively Coupled Plasma-Atomic Emission Spectroscopy (ICP-AES).

### (iii) Organic Medium

The organic medium is used as an organic binder. The organic medium in which the inorganic components such as the conductive powder and the glass frit are dispersed forms a "paste", having suitable viscosity for applying on a substrate.

The organic medium can contain an organic polymer and optionally a solvent. A wide variety of inert viscous materials can be used as an organic medium. In an embodiment, the organic polymer can comprise ethyl cellulose, ethylhydroxyethyl cellulose, wood rosin, phenolic resin, polymethacrylate of lower alcohol, or monobutyl ether of ethylene glycol monoacetate. When adding a solvent to the organic medium, the solvent can comprise texanol, ester alcohol, terpineol, kerosene, dibutylphthalate, butyl carbitol, butyl carbitol acetate, hexylene glycol or high boiling alcohols. The solvent is chosen in view of the organic polymer solubility. In an embodiment, the organic medium can be a mixture of ethyl cellulose and texanol.

The organic medium can be 10 to 69 wt% in an embodiment, 15 to 51 wt% in another embodiment, and 20 to 37 wt% in still another embodiment, based on the total weight of the Al paste.

### (iv) Additives

Thickener, stabilizer, viscosity modifier or surfactant can be optionally added to the Al paste. Other common additives such as a dispersant, viscosity-adjusting agent, and so on can also be added. The amount of the additive depends on the desired characteristics of the resulting electrically conducting paste. Multiple types of additives can be used.

### EXAMPLES

The present invention is illustrated by, but is not limited to, the fellowing examples.

### Aluminum Paste Preparation

An aluminum paste was prepared by the following procedure and materials. Weight percent (wt%) is herein based on the total weight of the aluminum paste unless otherwise mentioned.
- Aluminum (Al) powder: 72 wt% of spherical aluminum powder was used. Particle diameter (D50) was 7.5 µm, purity of the Al powder was 98 %.
- Glass frit: 1.25 wt% of glass frit was used. The glass frit composition and its softening point (Ts) used in each Example and in the Comparative Example is shown in Table 1. Particle diameter (D50) was 0.8 µm.
- Organic medium: 25.75 wt% of a mixture of ethyl cellulose and texanol was used.
- Additive: 1 wt% of a viscosity modifier was used.

The organic medium and the additive were mixed for 15 minutes, and then the Al powder and the glass frit were dispersed in the mixture to further mix for 30 minutes to form an Al paste. The Al paste was repeatedly passed through a 3-roll mill at progressively increasing pressures from 0 to 400 psi. The gap of the rolls was adjusted to 1 mil.

The viscosity as measured with Brookfield HBT viscometer with #14 spindle at 10 rpm and 25°C was 30 Pa•s. The degree of dispersion as measured by fineness of grind was 15/5 or less.

### Manufacture of Solar Cell Back Side Electrode

The Al paste was screen-printed onto an entire surface of a 100 µm thick silicon nitride passivation layer formed on the back side of a multi-crystalline Si wafer. The Si wafer was 30 mm wide, 30 mm long, and 120 µm thick. The passivation layer had round shaped openings 100 µm in diameter, 350 µm of pitch. The back surface of the Si wafer was exposed inside the openings of the silicon nitride layer.

The screen printed Al paste was dried at 150°C for 5 minutes in an oven. Thickness of the dried Al paste was 15 µm in average.

A solar cell back side electrode was obtained by firing the dried Al paste in a furnace (CF-7210, Despatch industry) at peak temperature setting with 945°C. The furnace set temperature of 945°C corresponded to a measured temperature at the upper surface of the silicon substrate of 750°C. Firing time from furnace entrance to exit was 60 seconds. The firing condition wa, 400 to 600°C for 12 seconds, and over 600°C for 6 seconds. The belt speed of the furnace was 550 cpm.

### Test Procedure of Adhesion

Adhesion of the back side electrode was measured by using a peel test. An adhesive tape (Scotch 810 Tape, 3M company) 18 mm wide and 30 mm long was put on the back side electrode and subsequently peeled off by hand.

### Result

The back side electrode did not peel off in Example 1 and 2, while the electrode was peeled off in Comparative Example 1 to 5.

**Table 1**

| | Glass frit composition | | | | | | | | | | Peel Test |
|---|---|---|---|---|---|---|---|---|---|---|---|
| | (starting material) | | | | | | | | | | |
| | PbO | Bi₂O₃ | SiO₂ | B₂O₃ | Al₂O₃ | ZnO | BaO | Sb₂O₃ | CaO | Ts | |
| | (Pb²⁺) | (Bi³⁺) | (Si⁴⁺) | (B³⁺) | (Al³⁺) | (Zn²⁺) | (Ba²⁺) | (Sb³⁺) | (Ca²⁺) | (°C) | |
| Example 1 | 50.0 | 0.0 | 22.0 | 26.0 | 2.0 | 0.0 | 0.0 | 0.0 | 0.0 | 420 | Not peeled off |
| | (39.1) | 0.0 | (17.2) | (40.7) | (3.1) | 0.0 | 0.0 | 0.0 | 0.0 | | |
| Example 2 | 53.2 | 0.0 | 13.7 | 27.1 | 6.1 | 0.0 | 0.0 | 0.0 | 0.0 | 420 | Not peeled off |
| | (39.9) | 0.0 | (10.3) | (40.6) | (9.2) | 0.0 | 0.0 | 0.0 | 0.0 | | |
| Com. Example 1 | 0.0 | 28.0 | 35.8 | 25.3 | 11.0 | 0.0 | 0.0 | 0.0 | 0.0 | 430 | Peeled off |
| | 0.0 | (34.1) | (21.8) | (30.7) | (13.4) | 0.0 | 0.0 | 0.0 | 0.0 | | |
| Com. Example 2 | 0.0 | 69.2 | 7.5 | 7.5 | 2.9 | 11.0 | 1.9 | 0.0 | 0.0 | 501 | Peeled off |
| | 0.0 | (35.3) | (14.8) | (25.6) | (6.8) | (16.1) | (1.5) | 0.0 | 0.0 | | |
| Com. Example 3 | 0.0 | 67.2 | 6.8 | 8.1 | 2.1 | 11.6 | 0.0 | 3.7 | 0.5 | 519 | Peeled off |
| | 0.0 | (33.9) | (13.4) | (27.2) | (4.7) | (16.7) | 0.0 | (3.0) | (1.1) | | |
| Com. Example 4 | 0.0 | 66.5 | 6.7 | 7.9 | 2.0 | 11.3 | 0.0 | 6.2 | 0.5 | 527 | Peeled off |
| | 0.0 | (33.2) | (13.1) | (26.7) | (4.6) | (16.4) | 0.0 | (5.0) | (1.0) | | |
| Com. Example 5 | 0.0 | 63.8 | 6.5 | 7.7 | 1.9 | 11.0 | 0.0 | 8.6 | 0.5 | 536 | Peeled off |
| | 0.0 | (32.5) | (12.8) | (26.1) | (4.5) | (16.0) | 0.0 | (7.0) | (1.0) | | |

| | | | | | | | | | | | |
|---|---|---|---|---|---|---|---|---|---|---|---|
| Note: Upper line shows mole% of starting materials PbO, Bi₂O₃, SiO₂, B₂O₃, and Al₂O₃. Lower line ( ) shows cation mole% of Pb²⁺, Bi³⁺, Si⁴⁺, B³⁺, and Al³⁺. | | | | | | | | | | | |

Next, it was determined whether the Al pastes of Example 1 and Example 2 fired through the passivation layer or not. Al electrodes were formed same as described above except that the pattern was two independent lines on the passivation layer which had no openings. If the Al paste fired through, there would be electrical continuity between the two line electrodes via the Si wafer. However, the electrical resistances between the electrodes were too high to measure. Therefore, it can be concluded that the Al paste did not fire through the passivation layer.

## Claims

1. A method of manufacturing a solar cell back side electrode comprising:
(a) preparing a substrate comprising a semiconductor layer and a passivation layer formed on the back side of the semiconductor layer, wherein the passivation layer has one or more openings;
(b) applying, onto the back side of the substrate, an aluminum paste comprising:
(i) an aluminum powder;
(ii) a glass frit comprising 30 to 70 cation mole percent of lead (Pb²⁺), 1 to 40 cation mole percent of silicon (Si⁴⁺) and 10 to 65 cation mole percent of boron (B³⁺), and 1 to 25 cation mole percent of aluminum (Al³⁺), based on the total mole of cationic components in the glass frit wherein the softening point of the glass frit is 330 to 550°C; and
(iii) an organic medium, wherein the aluminum paste covers the one or more openings in the passivation layer thereby making electrical contact with the semiconductor layer; and
(c) firing the aluminum paste in a furnace, wherein the aluminum paste does not fire through the passivation layer during the firing.

2. The method of claim 1, wherein the aluminum powder is 30 to 80 weight percent, the glass frit is 0.1 to 10 weight percent, and the organic medium is 10 to 69 weight percent, based on the total weight of the aluminum paste.

3. The method of claim 1, wherein the firing time is 10 seconds to 30 minutes.

4. The method of claim 1, wherein area of the one or more openings is at least 0.1 %, based on the total area of the back side surface of the semiconductor layer.

## Patentansprüche

1. Verfahren zur Fertigung einer Solarzellen-Rückseitenelektrode, umfassend:
(a) das Herstellen eines Substrats umfassend eine Halbleiterschicht und eine Passivierungssschicht, die auf der Rückseite der Halbleiterschicht gebildet ist, wobei die Passivierungsschicht eine oder mehrere Öffnungen aufweist;
(b) das Aufbringen, auf die Rückseite des Substrats, einer Aluminiumpaste umfassend:
(i) ein Aluminiumpulver;
(ii) eine Glasfritte umfassend 30 bis 70 Kationenmolprozent Blei (Pb²⁺), 1 bis 40 Kationenmolprozent Silicium (Si⁴⁺) und 10 bis 65 Kationenmolprozent Bor (B³⁺) und 1 bis 25 Kationenmolprozent Aluminium (Al³⁺), auf die gesamten Mole kationischer Komponenten in der Glasfritte bezogen, wobei der Erweichungspunkt der Glasfritte 330 bis 550 °C beträgt; und
(iii) ein organisches Medium, wobei die Aluminiumpaste die eine oder mehreren Öffnungen in der Passivierungsschicht bedeckt, wodurch ein elektrischer Kontakt mit der Halbleiterschicht hergestellt wird; und
(c) das Brennen der Aluminiumpaste in einem Ofen, wobei die Aluminiumpaste während des Brennens nicht durch die Passivierungsschicht hindurchbrennt.

2. Verfahren nach Anspruch 1, wobei das Aluminiumpulver 30 bis 80 Gewichtsprozent beträgt, die Glasfritte 0,1 bis 10 Gewichtsprozent beträgt und das organische Medium 10 bis 69 Gewichtsprozent, auf das Gesamtgewicht der Aluminiumpaste bezogen, beträgt.

3. Verfahren nach Anspruch 1, wobei die Brennzeit 10 Sekunden bis 30 Minuten beträgt.

4. Verfahren nach Anspruch 1, wobei der Bereich der einen oder mehreren Öffnungen mindestens 0,1 %, auf den Gesamtbereich der Rückseitenfläche der Halbleiterschicht bezogen, beträgt.

## Revendications

1. Procédé de fabrication d'une électrode arrière pour pile solaire comprenant:
(a) la préparation d'un substrat comprenant une couche semi-conductrice et une couche de passivation formée sur la face arrière de la couche semi-conductrice, où la couche de passivation présente une ou plusieurs ouverture(s);
(b) l'application, sur la face arrière du substrat, d'une pâte d'aluminium comprenant:
(i) une poudre d'aluminium;
(ii) une fritte de verre comprenant 30 à 70 pour cent en mole de cations de plomb (Pb²⁺), 1 à 40 pour cent en mole de cations de silicium (Si⁴⁺) et 10 à 65 pour cent en mole de cations de bore (B³⁺), et 1 à 25 pour cent en mole de cations d'aluminium (Al³⁺), sur la base des moles totales des composants cationiques dans la fritte de verre où le point de ramollissement de la fritte de verre est 330 à 550°C; et
(iii) un milieu organique, où la pâte d'aluminium recouvre la une ou les plusieurs ouverture(s) dans la couche de passivation constituant de là un contact électrique avec la couche semi-conductrice; et
(c) la calcination de la pâte d'aluminium dans un four, où la pâte d'aluminium n'est pas calcinée à travers la couche de passivation durant la calcination.

2. Procédé selon la revendication 1, dans lequel la poudre d'aluminium représente 30 à 80 pour cent en poids, la fritte de verre représente 0,1 à 10 pour cent en poids, et le milieu organique représente 10 à 69 pour cent en poids, sur la base du poids total de la pâte d'aluminium.

3. Procédé selon la revendication 1, dans lequel le temps de calcination est de 10 secondes à 30 minutes.

4. Procédé selon la revendication 1, dans lequel la zone de l'une ou des plusieurs ouverture(s) est d'au moins 0,1 %, sur la base de la zone totale de la surface de face arrière de la couche semi-conductrice.
